# EUROPEAN PATENT SPECIFICATION

(11) **EP 2 394 084 B1**
(45) Date of publication and mention of the grant of the patent: **02.08.2017**
(21) Application number: 10738813.4
(22) Date of filing: 02.02.2010
(51) Int. Cl.: H02G 3/22, F16L 5/08, F16L 5/14

(54) **MODULES OF PIPE OR CABLE LEAD-THROUGHS STICKING TOGETHER**
ZUSAMMENGEFÜGTE ROHR- ODER KABELDURCHFÜHRUNGSMODULE
MODULES DE PASSE-CÂBLES OU PASSES-CANALISATIONS COLLÉS LES UNS AUX AUTRES

(30) Priority: 04.02.2009 SE 0950046
(43) Date of publication of application: 14.12.2011
(73) Proprietor: Roxtec AB, 371 23 Karlskrona (SE)
(72) Inventor: ANDERSSON, Jens, S-370 23 Hasslö (SE); ERICSON, Mats, S-374 51 Asarum (SE); FILIPSEN, Jenny, S-371 31 Karlskrona (SE); HILDINGSSON, Ulf, S-370 24 Nättraby (SE); LUNDBORG, Christer, S-371 32 Karlskrona (SE); MILTON, Stefan, S-373 02 Ramdala (SE); PETTERSSON, Ronnie, S-373 00 Jämjö (SE); ÅKESSON, Jörgen, S-371 94 Lyckeby (SE)
(74) Representative: Ström & Gulliksson AB
(86) International application number: PCT/SE2010/050116
(87) International publication number: WO 2010/090582

(56) References cited:
- EP-A2- 0 429 916
- WO-A1-03/052895
- WO-A1-2005/057749
- WO-A1-2007/094736
- WO-A2-2005/078884
- AT-B- 377 129

## Description

### Technical Field

The present invention concerns a seal, lead-through or transit for cables, wires or pipes. The invention especially concerns module halves that stick together in large number. A suitable number of module halves are then separated in connection with installation.

### Prior Art

In the prior art there are cable transitions or the like having a frame, inside which a number of modules to receive cables, wires or pipes are placed. The modules are made of an elastic material e.g. rubber or plastics and are thus compressible. Inside the frame normally a number of modules are received side by side in one or more rows together with some kind of compression unit. The compression unit is placed between the frame and the modules in such a way that when the compression unit is expanded the compressible modules will be compressed around the cables, wires or pipes. For ease of description the expression "cable" is mainly used in this description, but it should be construed broadly and a person skilled in the art realises that it normally also covers pipes or wires.

Seals or transitions of the above kind are used for sealing in many different environments, such as for cabinets, technical shelters, junction boxes and machines. They are used in different industrial environments, such as automotive, telecom, power generation and distribution, as well as marine and offshore. The seals or transitions may have to seal against fluid, gas, fire, rodents, termites, dust, moisture etc., and may receive cables or wires for electricity, communication, computers etc., pipes for different gases or liquids such as water, compressed air, hydraulic fluid and cooking gas or wires for load retention.

The modules receiving a single cable etc. have a pack of peelable layers or sheets on the inside. The layers or sheets are peeled off until the inner diameter of the part is adapted to the outer diameter of the cable received in said part. The sheets adhere strong enough to each other to stay together and at the same time loose enough to enable the sheets to be peeled off from the stack, either one-by-one or a number of sheets together.

AT 377 129 B, which forms the basis for the two-part form of independent claim 1, shows a plate of module half blanks placed side by side. An incision is made in the plate between adjacent module half blanks.

In WO 03/052895 A1 different embodiments of cable retention devices are shown. In some embodiments a number of module halves are adhered to a support plate.

WO 2007/094736 is directed to a module comprising a block and a bush, which bush is placed in a central opening of the block. The block and bush can be opened at one side for lateral insertion of a cable.

EP 429 916 A2 shows different methods of producing modules.

A person skilled in the art realises that the exact shape and form of the different parts, including the layers, may vary without departing from the gist of the present invention. For example the pack of layers may have another cross sectional form than circular.

### Summary

One object of the present invention is to facilitate handling of module halves at installation as well as during transportation and storing. A further object is to make it possible to adapt the modules to different frames, i.e. frames of different dimensions. Still a further object is to facilitate production of module halves. These objects are achieved with the module mat defined in independent claim 1. According to the present invention compressible modules are to be placed in cable entries or pipe penetrations. The one or more compressible modules each surround a cable or pipe and which compressible modules are placed in a frame together with at least one compression unit. The compressible modules are formed of two module halves, each module half comprising a base part having a groove receiving a cable or pipe. In the groove a number of peelable layers, forming a stack of layers, is received. Before installation two or more module halves stick together along one or more separation lines.

At installation an appropriate number of module halves are separated from the rest of the module halves sticking together. The separated module halves may be separated in such a way that they still stick together. The module halves sticking together form a module mat. In that the module halves are produced in the form of module mats the producing process is simplified, for instance in that several modules are produced simultaneously. The exact lengths of the module halves and numbers of module halves that is to stick together at installation is decided just at the installation. Thus, handling is simplified in that the decision concerning the size and number of modules to use may be done at installation, giving a more flexible installation.

Further objects and advantages of the present invention will be obvious to a person skilled in the art when reading the detailed description below.

### Brief Description of the Drawings

The invention will be described more closely below by way of example and with reference to the enclosed drawings. In the drawings:
Fig. 1 is a plan view of one example of a cable or pipe transition,
Fig. 2 is a perspective view of a module half that may be used in the transition of Fig. 1,
Fig. 3 is a plan view of a module mat according to the present invention,
Fig. 4 is a perspective view of the module mat of Fig. 3 bent in a first direction,
Fig. 5 is a perspective view of the module mat of Fig. 3 bent in a second direction, and
Figs. 6 and 7 are perspective views indicating possible arrangements of module halves at installation.

### Detailed Description of Different Embodiments

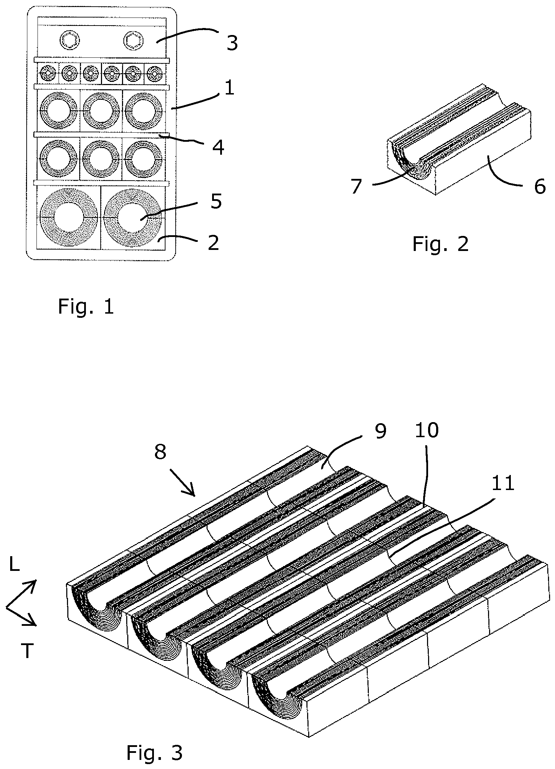

A common type of seals or transitions for cables and/or pipes is indicated in Fig. 1. It has an outer frame 1 received in a wall or any other type of partition. Inside the frame 1 a number of modules 2 are arranged to receive a single cable or pipe each. Furthermore, a compression unit 3 is received inside the frame 1. The modules 2 are separated by stay plates 4, which stay plates 4 are arranged to position the modules 2 safely inside the frame 1. The modules 2 are compressible parts of the seal or transition. Each module 2 has a central blind 5, which is removed when the cable or pipe is received.

An alternative system including a frame is described in the simultaneously filed application entitled "Sealing System", filed by the applicant of the present application.

In further alternative embodiments the seal, lead-through or transit of the present invention is furnished with means for lubrication as shown in the simultaneously filed application entitled "Lubrication of a Pipe or Cable Lead-Through", filed by the applicant of the present application.

In Fig. 2 a module half is shown, which corresponds with the modules 2 of Fig. 1. The module half has a base part 6 with a generally rectangular appearance, having a semi cylindrical groove at one side. Inside the semi cylindrical groove of the base part 6 a number of peelable sheets or layers 7 are received. In use two module halves are put together with the grooves facing each other. The module thus formed will have a central cylindrical opening, in which a cable or pipe is to be received. When a cable or pipe is to be received an appropriate number of layers 7 are peeled off from each base part 6 in order to adapt the inner diameter of the cylindrical opening of the module to the outer diameter of the cable or pipe to be received. Thus, when a module 2 is to receive a cable or a pipe the blind 5 is first removed and then a number of layers 7 are peeled off. When all pipes and/or cables have been placed in a module 2 each, the compression unit 3 is activated. The function of the compression unit 3 is to expand inside the frame 1. As the compression unit expands it will compress the modules 2, which are made of a compressible material such as rubber. The modules 2 will be compressed in one direction and expand in other directions, pressing the modules 2 against the frame 1 and cables.

Alternative embodiments of the modules are given in the simultaneously filed applications entitled "A Pipe or Cable Lead-Through having a Part Indicating Compression", "Eccentric Part of a Pipe or Cable Lead-Through", "A Module of a Pipe or Cable Lead-Through having Grooves on Opposite Sides", "Pipe or Cable Lead-Through Blocks", "A Pipe or Cable Lead-Through having Modularized Modules", "A Pipe or Cable Lead-Through having Penetratable Modules" and "A Pipe or Cable Lead-Through having Modules with a Dimensioning Function", filed by the applicant of the present application.

The sheets may be arranged in many different ways and with different features as reflected in the simultaneously filed applications entitled "A Pipe or Cable Lead-Through having Interconnected Layers", "A Pipe or Cable Lead-Through having Layers of Different Thickness", "Cohering Between Layers of a Pipe or Cable Lead-Through" and "Identification of Layers of a Pipe or Cable Lead-Through", filed by the applicant of the present application.

In Figs. 3-5 one example of a module mat 8 is shown, formed of a number of module halves 9. Each module half 9 corresponds with the module half shown in Fig. 2. The module halves 9 of the module mat 8 sit together along longitudinal and transversal separation lines 10, 11. As used in this description the longitudinal and transversal directions are as indicated in Fig. 3, where L stands for longitudinal direction and T for transversal direction. The separation lines 10, 11 are placed at lower edges of the module halves 9.

To facilitate separation the separation lines 10, 11 are normally perforated, whereby the module halves 9 normally are possible to separate by hand. In other embodiments the material of the separation lines 10, 11 is that thin that the module halves 9 may be separated by hand even without perforations.

In one embodiment the separation lines 10, 11 are formed together with the module halves 9. In other embodiments the module halves 9 are connected to each other at the lower edges by means of an adhesive or by welding. It is also possible to adhere the module halves 9 to a carrier by means of an adhesive. Thus, the separation lines 10, 11 may be formed of the same material as the module halves 9, by an adhesive, by a weld or by a carrier. A possible carrier of the module mat may be made of metal to give a RFI shield. It is also possible to include an intumescing material in the carrier for fire protection. In a further embodiment the carrier is made of threads or ties glued to the modules or clamped in small recesses of the modules.

If a row of for example three modules are to be placed in a frame, three module halves 9 are separated from the module mat 8 in such a way that the three module halves still sits together. The three module halves 9 may then be inserted into a frame as one unit.

If an installation calls for two or more modules in a longitudinal direction they may be separated from the module mat 8 in the same way as described above and still sticking together.

Installation is made easier in that the module halves 9 stick together and one have fewer loose parts to consider. This may be especially beneficial at horizontal installation.

Handling of the module halves 9 is facilitated in that for installation only one module mat 8 is needed. From that module mat 8 an appropriate number of module halves 9 are separated from the rest of the module mat 8. If needed several module mats 8 having module halves 9 of different dimensions are used. In each module mat 8 the module halves 9 are of the one and same dimension.

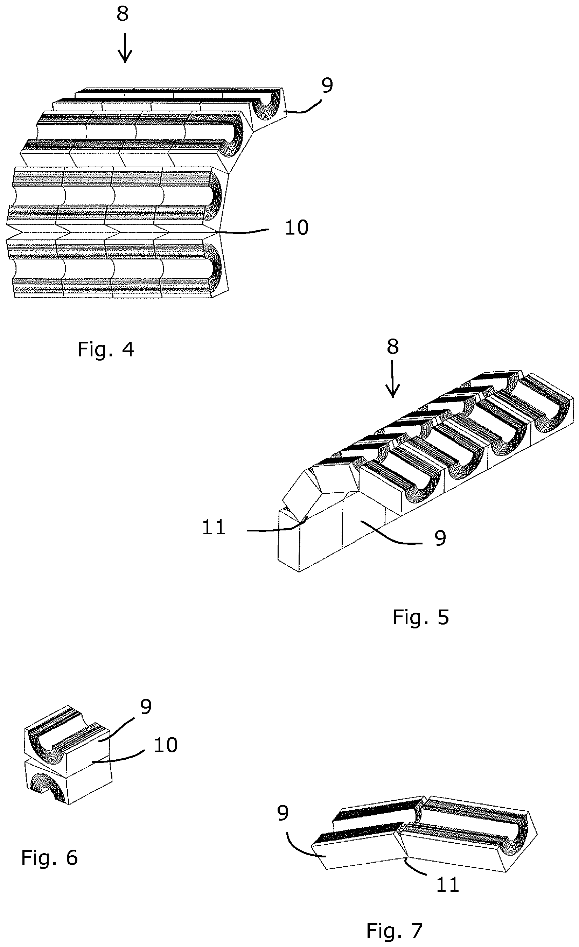

As indicated in Figs. 6 and 7 it is possible to place two module halves 9 on top of each other while they still stick together. In this case the separation lines 10, 11 form a bridge between the module halves 9. By placing two module halves 9 on top of each other at installation there are fewer loose parts to consider at installation. As shown the module halves 9 of these examples stick together either at a longitudinal separation line 10 or a transversal separation line 11. Even though only one module is shown in Figs. 6 and 7 a person skilled in the art realises that a row of several modules placed side by side may also be placed on top of another row of several modules, while the rows still stick together.

## Claims

1. Module mat (8) of compressible module halves (9) of compressible modules for cable entries or pipe penetrations to receive one or more of said compressible modules (2) each surrounding a cable or pipe, which compressible modules (2) are to be placed in a frame (1) together with at least one compression unit (3), wherein each compressible module (2) is formed of two module halves (9) each comprising a base part (6) having on an upper side a groove receiving a cable or pipe wherein the module mat (8) is formed by a number of said module halves (9) sticking together along separation lines (10) facilitating separation of the module halves (9), and wherein the module halves (9) are to be separated from each other along the separation lines (10) having a longitudinal extension with respect to the grooves, **characterised in that** in said groove a number of peelable layers (7), forming a stack of layers, is received, that further separation lines (11) facilitating separation of the module halves (9) having a transversal extension with respect to the grooves are provided, and that the longitudinal and transversal separation lines (10, 11) are placed at lower edges of the module halves (9).

2. The arrangement of claim 1, wherein the separation lines (10, 11) are perforated.

3. The arrangement of claim 1 or 2, wherein the material of the separation lines (10, 11) makes it possible to separate the module halves (9) by hand.

4. The arrangement of any of the previous claims, wherein the module halves (9) are connected to each other by means of welding or by means of an adhesive.

## Patentansprüche

1. Modulmatte (8) von zusammendrückbaren Modulhälften (9) von zusammendrückbaren Modulen für Kabeleintritte oder Rohrdurchführungen, um eines oder mehrere besagter zusammendrückbarer Module (2), jeweils umgebend ein Kabel oder ein Rohr, aufzunehmen, welche zusammendrückbaren Module (2) in einem Rahmen (1) zusammen mit wenigstens einer Kompressionseinheit (3) angeordnet sind, wobei jedes zusammendrückbare Modul (2) aus zwei Modulhälften (9) gebildet ist, jeweils umfassend ein Basisteil (6) mit, auf einer oberen Seite, einer Rille aufnehmend ein Kabel oder ein Rohr, wobei die Modulmatte (8) durch eine Anzahl besagter Modulhälften (9) gebildet ist, die entlang von Trennlinien (10) zusammenstecken, erleichternd eine Trennung der Modulhälften (9), und wobei die Modulhälften (9) voneinander entlang der Trennlinien (10) mit einer Längserstreckung in Bezug auf die Rillen voneinander zu trennen sind, **dadurch gekennzeichnet, dass** in besagter Rille eine Anzahl von abziehbaren Schichten (7), ausbildend einen Stapel an Schichten, aufgenommen ist, dass weitere Trennlinien (11), die eine Trennung der Modulhälften (9) mit einer Quererstreckung in Bezug auf die Rillen erleichtern, bereitgestellt sind, und dass die Längs- und Quertrennlinien (10, 11) an unteren Rändern der Modulhälften (9) angeordnet sind.

2. Anordnung nach Anspruch 1, wobei die Trennlinien (10, 11) perforiert sind.

3. Anordnung nach Anspruch 1 oder 2, wobei das Material der Trennlinien (10, 11) es ermöglicht, die Modulhälften (9) per Hand zu trennen.

4. Anordnung nach einem der vorangehenden Ansprüche, wobei die Modulhälften (9) miteinander mittels einer Verschweißung oder mittels eines Klebstoffs verbunden sind.

## Revendications

1. Matrice de module (8) de moitiés de module compressible (9) de modules compressibles pour des entrées de câbles ou des pénétrations de canalisation pour recevoir un ou plusieurs desdits modules compressibles (2) chacun entourant un câble ou une canalisation, lesquels modules compressibles (2) doivent être placés dans un cadre (1) conjointement avec au moins une unité de compression (3), dans lequel chaque module compressible (2) est formé de deux moitiés de module (9) chacune comprenant une partie de base (6) ayant sur un côté supérieur une rainure recevant un câble ou une canalisation dans lequel la matrice de module (8) est formée par un nombre desdites moitiés de module (9) collées ensemble le long de lignes de séparation (10) facilitant la séparation des moitiés de module (9), et dans lequel les moitiés de module (9) doivent être séparées les unes des autres le long de lignes de séparation (10) ayant une extension longitudinale par rapport aux rainures, **caractérisé en ce que** dans ladite rainure un nombre de couches pelables (7), formant un empilement de couches, est reçu, que des lignes de séparation supplémentaires (11) facilitant la séparation des moitiés de module (9) ayant une extension transversale par rapport aux rainures sont fournies, et que les lignes de séparation longitudinales et transversales (10, 11) sont placées aux bords inférieurs des moitiés de module (9).

2. Agencement selon la revendication 1, dans lequel les lignes de séparation (10, 11) sont perforées.

3. Agencement selon la revendication 1 ou 2, dans lequel le matériau des lignes de séparation (10, 11) rend possible la séparation des moitiés de module (9) à la main.

4. Agencement selon une quelconque des revendications précédentes, dans lequel les moitiés de module (9) sont reliées les unes aux autres au moyen de soudure ou au moyen d'un adhésif.
